Europäisches Patentamt

(19) **European Patent Office**

Office européen des brevets

(11) Publication number: **0 260 232**
**B1**

## EUROPEAN PATENT SPECIFICATION

(45) Date of publication of the patent specification:
**23.05.90**

(51) Int. Cl.[5]: **H01L 21/60**

(21) Application number: **87830297.5**

(22) Date of filing: **30.07.87**

(54) Process for making metal-semiconductor ohmic contacts.

(30) Priority: **28.08.86 IT 8363886**

(43) Date of publication of application:
**16.03.88 Bulletin 88/11**

(45) Publication of the grant of the patent:
**23.05.90 Bulletin 90/21**

(84) Designated Contracting States:
**DE FR GB NL**

(56) References cited:
**EP-A- 0 186 296**
**EP-A- 0 219 465**
**US-A- 4 516 145**

**SOLID STATE TECHNOLOGY, vol. 27, no. 4, April 1984, pages 191-196, Port Washington, New York, US; J. DIELEMAN et al.: "Plasma effluent etching: selective and non-damaging"**
**IEEE TRANSACTIONS ON ELECTRON DEVICES, vol. ED-28, no. 11, November 1981, pages 1323-1331, IEEE, New York, US; K. HIRATA et al.: "Dry etching technology for 1-mum VLSI fabrication"**
**IEEE TRANSACTIONS ON ELECTRON DEVICES, vol. ED-32, no. 7, July 1985, pages 1328-1333, IEEE, New York, US; J.K. MANJIN et al.: "Mo/TiW contact for VLSI applications"**

(73) Proprietor: **SGS-THOMSON MICROELECTRONICS s.r.l., Via C. Olivetti, 2, I-20041 Agrate Brianza Milano(IT)**

(72) Inventor: **Gualandris, Fabio, Via Degli Albani, 17, I-24100 Bergamo(IT)**

(74) Representative: **Pellegri, Alberto et al, c/o Società Italiana Brevetti S.p.A. Via Cavour, 9, I-21100 Varese(IT)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to an improved process for making ohmic-type contacts between a metal and a semiconductor, particularly p or n doped silicon.

In fabricating monolithically integrated circuits as well as in fabricating discrete semiconductor devices according to the most differentiated technologies used for making such devices, it is necessary to form ohmic contacts between the semiconductor material, for example p or n doped silicon and a metallic material, i.e. a material exhibiting a metallic conduction utilized for forming the necessary electrical interconnections on the front side of the integrated circuit.

This type of contact being formed between a metallic conduction material and a monocrystalline semiconductor material must exhibit an essentially linear current-voltage characteristic, symmetric about the origin (ohmic contact), i.e. it must not give raise to "rectification" of the current, neither to noticeable non-linearities, at least within a certain region about the origin of the V-I axes (compatible with the maximum current levels contemplated) under the foreseeable operating conditions (temperature, irradiation, etc.).

Moreover, the contact resistance must be as low as possible for obvious reasons of containing power dissipation, for fast switching times especially in EPROM type devices, for a good threshold level discrimination in GATE ARRAY type logic devices, etc..

The material having a metallic conduction presently utilized according to state-of-the-art technologies may be of various nature: aluminum, alloyed aluminum (containing silicon or copper-silicon or titanium-silicon in amounts not greater than 3% by weigth), tungsten, tantalum, titanium, alloys thereof, silicides and doped polycrystalline silicon are all examples of suitable materials used commercially.

More recently, especially in relation to high integration degree technologies (VLSI), wherein, for miniaturization reasons, the diffused regions have extremely small thicknesses, the contacts are made by means of the so-called "barrier metallurgy" techniques, which contemplate the deposition over the exposed surface of the silicon of a first thin layer of a material having a metallic conductivity and a negligeable ability to diffuse into the silicon together with a substantial imperviousness to the diffusion of dopants present in the silicon in order not to "deplete" the junction region made so thin for the reasons mentioned before. A suitable barrier material is for example titanium.

Over such a first barrier layer a second barrier layer is usually deposited (e.g. titanium nitride). The material making this second barrier layer is choosen among materials showing a substantial imperviousness to the diffusion of aluminum; and over such a second barrier layer a metallization layer having a sufficient thickness for obtaining the desired electrical conductivity of the conducting paths, defined on the front side of the device, customarily of aluminum or of an aluminum alloy, may be deposited.

In the majority of the fabrication processes of such semiconductor devices, one of the crucial technical problems in forming the ohmic contacts is inherent to the techniques used for "opening" the contacts; i.e. to the wet or dry (in plasma) etching techniques used for attacking the dielectric material layer present on the surface of the monocrystalline silicon until exposing the latter in correspondence to relative windows defined by means of a photoresist mask.

Substantially, the contact resistance is strongly influenced by the state of the monocrystalline silicon surface over which the material or the materials having a metallic conductivity are deposited for forming the ohmic contact. The presence of residues of dielectric material, a possible re-oxidation of the exposed surface of the semi conductor in contact with the room atmosphere, the presence on the exposed surface of the semiconductor of residues of polymeric material being generated during the plasma etch treatments, the "implantation" of hydrogen atoms into the crystal lattice of the semiconductor are some of the factors to which relatively high contact resistances are often attributed.

Such consequences of the treatments used for preparing the silicon surface of the contacts are hardly controlled and cause a remarkable depression of the production yields.

A number of proposals for improving the techniques for preparing the contact areas have addressed different aspects of the technical problem. More recently, the widespread adoption of metallurgical barrier techniques of the type mentioned above, appears to have increased and extended the technical problem to ohmic contacts formed over $p^+$ doped silicon, which notably had less problems when they used to be formed by directly depositing aluminum or polycrystalline silicon over the contact area.

Such events appear to have, indirectly, given credit to the contention which points to the hydrogen atoms, involuntarily introduced in the silicon of the junction region through an implantation phenomenon due to the DC self-bias generated by the plasma itself and coming from the plasma components commonly used for the dry etching of the dielectric layer for "opening" the contacts, as the main responsible for high contact resistances.

Normally in fact, the dry attack is protracted until surely exposing the silicon over the entire area of the contact and this necessarily implies a certain "overetch", i.e. a certain final period during which also the silicon is exposed to plasma etching.

Commonly, such a dry etching treatment is carried out in a plasma of $CHF_3 + O_2$, in R.I.E. configuration (acronym of Reactive Ion Etching), and the ionized hydrogen of the $CHF_3$ groups is captured by the silicon during such a final period of "overetch". The following deposition of a metallurgical barrier such as the one represented by titanium/titanium nitride over the silicon surface would allegedly prevent the hydrogen atoms introduced into the crystal lattice of the silicon to rediffuse outside of the silicon during the subsequent heat treatment for "alloying" the different layers deposited, which usually follows the process step of definition of the metal "strips". Instead, this subsequent heat treatment would be responsible for the diffusion of the H atoms through the diffused region of the junction and, according to recent studies, these hydrogen atoms, in p doped silicon, would disactivate the acceptors and thus would lead to a depletion of the junction with consequent problems of a high contact resistance.

Prior proposals for overcoming this problem contemplate arresting the R.I.E. plasma etch of the dielectric layer before exposing the underlying monocrystalline silicon surface and to proceed to remove this residual thickness and to expose the silicon by means of a dry etching using a non-polymerizing, hydrogen-free plasma. These solutions present problems in controlling the large number of parameters influencing the preparation of the contacts, such as for example thickness uniformity of the dielectric layer (which is often a composite multilayered material), disuniformities of the etch rates, difficulties in controlling the etch rates for the various layered materials and yet other processing problems make these proposals commercially unactractive.

DESCRIPTION OF THE INVENTION

It is, therefore, a main objective of the present invention to provide an improved process for making metal-semiconductor ohmic contacts free of the drawbacks of the known processes.

The process of the present invention for making ohmic type contacts between a metal and a semiconductor on as many areas of the surface of a monocrystalline semiconductor wafer defined by means of a photoresist mask and exposed by etching a layer of dielectric material through the openings of said mask, essentially comprises the following steps such as disclosed in claim 1.

After the heat treatment under inert atmosphere of the wafers and before proceeding to the sputter deposition of the metallic material, the wafers may be subjected to one or more of the known cleaning treatments for removing eventual contaminants from the exposed surfaces of the contacts which may have deposited over the exposed areas during handling of the wafers, as well as for removing eventual re-oxidation film over the exposed surfaces of the semiconductor material, which may have formed because of prolonged exposure to ambient atmosphere.

Such a prolonged heat treatment in inert atmosphere at a relatively high temperature of the wafers appears to have a decisively positive effect on the quality of the ohmic contacts. It appears suitable to overcome effectively the problem represented by the absorption of hydrogen atoms by the monocrystalline semiconductor material during the terminal phase of the R.I.E. plasma attack of the dielectric material layer through the openings of the photoresist mask.

A nonequivocal confirmation of the efficaciousness of the new process, object of the present invention, is represented by the fact that by utilizing the new process of the invention for making ohmic type contacts between p+ doped silicon and a metallurgical barrier multilayer, formed by a first layer of titanium, a second layer of titanium nitride (total thickness of about 1000 Å) and an aluminum layer (about 9000 Å thick), contacts thus formed where found to be totally exempt from problems of a relatively high contact resistance and substantially comparable with ohmic contacts formed over the same semiconductor, by means of the same procedure for opening the contacts, but without utilizing any metallurgical barrier, i.e. depositing the aluminum layer directly over the exposed p+ doped silicon.

Although a suitable method of qualitative/quantitative analysis is still missing, it is reasonably believed that the mechanism through which the heat treatment under inert atmosphere of the wafers, after the R.I.E. plasma etch treatment for opening the contacts with a plasma containing polymerizing halogenated compounds (i.e. hydrocarbon fluorides), is instrumental in ensuring a low contact resistance, be as follows.

The hydrogen ions of the plasma impinging on the surface of the silicon during the terminal stage of attack (overetch) and absorbed into the superficial layers of the monocrystalline silicon, during the subsequent heat treatment under inert atmosphere, diffuse along all directions and a considerable portion of them "re-diffuses out" of the crystal; i.e. the hydrogen atoms reaching the surface of the crystal lattice combine to form molecular hydrogen ($H_2$) "vaporizing" in the atmosphere of the treatment chamber.

Thus the heat treatment under inert atmosphere would have the function of a decontamination treatment for the hydrogen "implanted" into the silicon during the etching process for opening the contacts (de-hydrogenation) and such a reduction of the quantity of hydrogen which, probably inevitably, remains into the silicon is anyway such as to prevent manifestations of anormally high contact resistance imputable to hydrogen contamination of the semiconductor.

The de-hydrogenation heat treatment is conducted at a temperature comprised between 450 and 700°C. Below 450°C the processes leading to the release of hydrogen by the silicon crystal appear to have an insufficient rate and it is possible that the mechanism of diffusion through the crystal lattice of the silicon prevail in respect of the mechanism of superficial combination to molecular hydrogen. The upper limit of the treatment temperature, about 700°C, is imposed by the opportunity of preventing an eccessive diffusion of the dopants within the silicon. A treatment temperature of about 600°C is preferred together with a treatment time of about an hour or more and more preferably of about 3 hours. Naturally to higher treatment temperatures will correspond shorter treatment times and viceversa.

The process of the invention besides being particularly simple notwithstanding its surprising efficaciuosness, has the advantage of not requiring wet etching treatments which are evermore incompatible with fabrication processes of large integration scale devices.

Even in respect of the most recent proposals which substantially contemplate special final etch treatments of the silicon surface under hydrogen free conditions for removing the contaminated superficial portion of the silicon, the process of the present invention offers the advantage of not requiring any further etch of the silicon, which may often lead to an untolerable thinning out of the junction region within the silicon.

These aspects make the new process, object of the present invention, particularly suitable to be used in modern fabrication processes for devices of a high degree of integration (VLSI and ULSI), wherein the so-called "metallurgical barrier" technique is utilized for forming metal-semiconductor ohmic contacts, and which technique, as already said, has dramatized the problem due to hydrogen contamination of the semiconductor during the etch process for opening the contacts, extending the problem also to contacts formed over p+ doped silicon which used to be less susceptible than those formed over n+ doped silicon.

According to a particularly preferred embodiment of the invention, the improved process for making metal-semiconductor ohmic contacts over distinct p+ and n+ diffused regions on a monocrystalline silicon wafer, covered with a layer of dielectric material (e.g. constituted by a first layer of thermally grown silicon oxide having a thickness of about 1500 Å, a second layer of silicon oxide chemically deposited from vapor phase, having a thickness of about 500 Å and a third layer of silicon oxide, doped with boron and phosphorus (PBSG), deposited from vapor phase and having a thickness of about 5000 Å) comprises the following operations.

Firstly a layer of photoresist resin having a thickness of about 15000 Å is disposed over the surface of the wafer.

By means of known photolithographic techniques utilizing an appropriate mask, the areas over which the ohmic contact between a material having a metallic conductivity which will be deposited successively over the surface of the wafer and the silicon are defined by opening suitable windows through the photoresist layer.

After eventual cleaning steps, a number of wafers are placed in mounting frames of an electrode of a R.I.E. plasma etch reactor and etching of the multilayered film of dielectric is effected through the openings of said photoresist mask.

Etching is conducted preferably at the following operations conditions:

- pressure: about 50 millitorr
- plasma composition and relative flows: CHF₃ at 60 SCCM (standard cm³ per minute) O₂ at 40 SCCM
- temperature: maintained constant and comprised between 20 and 25°C
- power transferred to the plasma: about 1350 W
- bias: comprised between 500 and 600 V.

Under these attack conditions a selectivity ratio between the rate of attack of the silicon oxide and of the photoresist of about 1:1 is obtained, i.e. the etching rates if the two materials are substantially similar.

Generally, the volumetric ratio between CHF₃ and O₂ is under all conditions preferably comprised between 2.5 and 3.5:2 during this process step.

As it is well known to the skilled technician, the attack conditions may also be suitably adjusted in order to obtain a tapered or vertical attack.

The etch rate of the silicon oxide is of about 500 Å/min..

The etch is conducted until completely exposing the silicon over the entire area of the contact and, typically, an "overetch" of about 30-35% is adopted, i.e. the attack is protracted after the silicon begins to be exposed to the etch for a further 30-35% of the total time of the etch treatment, which usually has a total duration of about 20 minutes.

Having "opened the contacts", the process proceeds in a customary way with a "barrel" treatment step for removing the residual masking photoresist.

The wafers are then introduced in an oven or heat treatment chamber where, under an inert atmosphere, preferably in nitrogen, are kept for about three hours at a temperature of 600°C.

At this point the wafers may be subjected to a cleaning treatment, preferably by means of a dry etch treatment of few seconds in a plasma of C₂F₆ + He in a volumetric ratio of 2:1.

Furthermore, the wafers may be subjected further to an acid wash in FPN (a commercial solution of ammonium phosphate, ammonium fluoride and phosphoric acid in deionized water) immediately before being introduced into the sputtering chamber for depositing the metallization layer or the different metallizing layers in accordance with a metallurgical barrier technique.

Naturally other cleaning procedures may be employed before the sputtering deposition of the metals, which is carried out according to standard procedures.

The fabrication process of the devices will proceed, normally, with the step of definition of the metal strips, with an eventual alloying heat treatment and so forth.

## Claims

1. A process for making ohmic type contacts between a metal and a semiconductor, over as many areas of the surface of a monocrystalline semiconductor wafer as defined by means of a photoresist mask and exposed by etching a layer of dielectric material through openings of said mask, comprising the following steps:
   1) R.I.E. plasma etching the layer of dielectric material in a plasma of a polymerizable hydrocarbon halide through the openings of said mask with a certain overetch for exposing the semiconductor surface in areas to be contacted;
   2) removing the residual masking photoresist;
   3) heat treating the wafer at a temperature comprised between 450 and 700°C under inert atmosphere and for a period of time comprised between 1 and 4 hours, while maintaining exposed the semiconductor surface within said etched areas and evaporating off the etched semiconductor areas hydrogen atoms which had become implanted in the semiconductor during said overetch treatment;

4) depositing by sputter deposition a layer of at least a material having a metallic conductivity at least over said etched and subsequently dehydrogenated areas of the semiconductor.

2. The process according to claim 1, wherein said semiconductor material is silicon.

3. The process according to claim 1, wherein said material having a metallic conductivity is multilayered and comprises a first barrier layer of titanium, a second layer of titanium nitride and third layer of aluminum.

4. The process according to claim 1, wherein said overetch is comprised between 30 and 35% of said dielectric material layer.

5. The process according to claim 1, wherein after said heat treatment under inert atmosphere for evaporating off implanted hydrogen atoms and before the sputter deposition, said wafer is subjected to a plasma etch in a plasma of $C_2F_6$+He for few seconds.

6. The process according to claim 5, wherein after said plasma etch treatment the wafer is subjected to an acid wash in a diluted solution of phosphoric acid, ammonium fluoride and ammonium phosphate.

**Patentansprüche**

1. Verfahren zur Durchführung von Verbindungen ohmischer Sorte zwischen einem Metall und einem Halbleiter, auf allen Zonen der Fläche eines halbleitenden Einkristallplättchens, die durch eine Photoresistmaske begrenzt und mittels Ätzung einer Schicht eines dielektrischen Materials durch Öffnungen der genannten Photoresistmaske belichtet werden, das durch die folgenden Stufen gekennzeichnet ist:

1) R.I.E. Plasmaätzung der Schicht aus dielektrischem Material in einem Plasma eines polymerisierbaren halogenierten Kohlenwasserstoffes durch die Öffnungen der genannten Photoresistmaske mit bestimmter Überätzung um die Halbleiterfläche in den in Berührung zu bringenden Zonen auszusetzen;

2) Entfernung der restlichen Photoresistmaske;

3) Wärmebehandlung des Plättchens bei einer Temperatur zwischen 450 und 700°C unter Schutzatmosphäre und auf einer Zeitdauer zwischen 1 und 4 Stunden, unter Beibehaltung der Belichtung der Halbleiterfläche innerhalb der genannten geätzten Zonen und Abdampfen der Wasserstoffatome aus den geätzten Zonen des Halbleiters, die während der genannten Überätzung im Halbleiter eingesetzt wurden;

4) Auflage durch Spritzenablagerung einer Schicht aus mindestens einem Material mit metallischer Leitfähigkeit über mindestens die genannten geätzten und dann dehydrierten Zonen des Halbleiters.

2. Verfahren nach Anspruch 1, dadurch gekennzeichnet, dass der genannte Halbleiter Silizium ist.

3. Verfahren nach Anspruch 1, dadurch gekennzeichnet, dass das genannte Material mit metallischer Leitfähigkeit mehrschichtig ist und eine erste Sperrschicht aus Titanium, eine zweite Schicht aus Titaniumnitrid und eine dritte Schicht aus Aluminium enthält.

4. Verfahren nach Anspruch 1, dadurch gekennzeichnet, dass die genannte Überätzung sich über 30 bis 35% der genannten Schicht aus dielektrischem Material erstreckt.

5. Verfahren nach Anspruch 1, dadurch gekennzeichnet, dass nach der genannten Wärmebehandlung unter Schutzatmosphäre zum Abdampfen der eingesetzten Wasserstoffatome und vor der Spritzenablagerung wird das genannte Plättchen einer Ätzung in einem Plasma von $C_2F_6$+He während einiger Sekunden unterworfen.

6. Verfahren nach Anspruch 5, dadurch gekennzeichnet, dass das Plättchen, nach der genannten Ätzbehandlung in Plasma, einem Säurewaschen in einer verdünnten Lösung von Phosphorsäure, Ammoniumfluorid und Ammoniumphosphat unterworfen wird.

**Revendications**

1. Procédé de réalisation de contacts de type ohmique entre un metal et un semiconducteur, sur toutes les aires de la surface d'un wafer semiconducteur monocristallin définies par une masque photorésistante et exposées par attaque d'une couche de matériel diélectrique à travers les ouvertures de ladite masque, comprenant les stades suivants:

1) attaque à plasma R.I.E. de la couche du matériel diélectrique dans un plasma d'un hydrocarbure halogéné polymerisable à travers les ouvertures de ladite masque avec une certaine attaque profonde pour exposer la surface du semiconducteur dans les aires à contacter;

2) élimination de la couche residue photorésistante de masquage;

3) traitement à la chaleur du wafer à une température comprise entre 450 et 700°C sous atmosphère inerte et pour une durée comprise entre 1 et 4 heures, tout en maintenant exposée la surface du semiconducteur à l'interieur desdites aires attaquées et éliminant par évaporation des aires attaquées du semiconducteur les atomes d'hydrogène qui ont été insérés dans le semiconducteur lors dudit traitement d'attaque profonde;

4) déposition par pulvérisation d'une couche d'au moins un matériel ayant une conductivité métallique au moins sur lesdites aires attaquées et successivement déshydrogénées du semiconducteur.

2. Procédé selon la revendication 1, caractérisé en ce que ledit matériel semiconducteur est silicium.

3. Procédé selon la revendication 1, caractérisé en ce que ledit matériel ayant conductivité métallique est à plusieurs couches et comprends une première couche-barrière de titanium, une deuxième couche de nitrure de titanium et une troisième couche d'aluminium.

4. Procédé selon la revendication 1, caractérisé en ce que ladite attaque profonde est comprise entre 30 et 35% de ladite couche de matériel diélectrique.

5. Procédé selon la revendication 1, caractérisé en ce qu'après ledit traitement à la chaleur sous atmosphère inerte pour éliminer par évaporation les atomes d'hydrogène insérés, et avant la déposition par pulvérisation, ledit wafer est sousmis à une attaque dans un plasma de $C_2F_6$+He pour quelques secondes.

6. Procédé selon la revendication 5, caractérisé en ce qu'après ledit traitement d'attaque au plasma le wafer est soumis à un lavage acide dans une solution diluée d'acide phosphorique, fluorure d'ammonium et phosphate d'ammonium.